# EUROPEAN PATENT APPLICATION

(11) **EP 2 369 631 A2**
(43) Date of publication of application: **28.09.2011**
(21) Application number: 11159151.7
(22) Date of filing: 22.03.2011
(51) Int. Cl.: H01L 31/032, H01L 31/0216, H01L 31/0336

(54) **Thin film photovoltaic cell**

(30) Priority: 25.03.2010 US 731748
(71) Applicant: Rohm and Haas Electronic Materials LLC, Marlborough, MA 01752 (US)
(72) Inventor: Khanarian, Garo, Princeton, NJ 08540 (US); Pugliano, Nicola, Grafton, MA 01519 (US); Szmanda, Charles R., Westborough, MA 01581 (US); Yi, Jae Hyung, Cambridge, MA 02141 (US)
(74) Representative: Buckley, Guy Julian

(57) **Abstract**

A thin film photovoltaic cell is provided having a substrate; a back contact provided on the substrate; a p-type semiconductor absorber layer provided on the back contact; a n-type semiconductor layer provided on the p-type semiconductor absorber layer; a dielectric organic material layer provided on the n-type semiconductor layer; a transparent conductive film provided on the dielectric organic material layer; and, optionally, an antireflective layer provided on the transparent conductive film. Also provided is a method of manufacturing a thin film photovoltaic cell.

## Description

The present invention relates to the field of thin film photovoltaic cells. More particularly, the present invention relates to a thin film photovoltaic cell stack and to a method for the manufacture thereof.

Interest in thin film photovoltaic cells has increased in recent years. This increased interest may be credited to improvements in conversion efficiency of cells made at the laboratory scale, and the anticipation that manufacturing costs can be significantly reduced compared to the older and more expensive crystalline and polycrystalline silicon technology. The term "thin-film" is used to distinguish this type of solar cell from the more common silicon based cell, which uses a relatively thick silicon wafer. While single crystal silicon cells still hold the record for conversion efficiency at over 20%, thin-film cells have been produced which perform close to this level. Therefore, performance of the thin-film cells is no longer the major issue that limits their commercial use. One significant hurdle remaining for the large scale commercialization of thin film photovoltaic cells is cost. The primary candidates for economical thin film photovoltaic cell absorber materials are polycrystalline compound semiconductor materials (i.e., CdTe and Cu(In,Ga)(S,Se)₂).

Conventional CdTe and Cu(In,Ga)(S,Se)₂ based thin film photovoltaic cells have a stacked multilayer structure. Such thin film photovoltaic cells have a substrate (e.g., glass) with a molybdenum back contact formed thereon. A p-type semiconductor absorber layer of CdTe or Cu(In,Ga)(S,Se)₂ is formed over the molybdenum back contact. An n-type semiconductor, buffer layer (e.g., CdS) is formed on the p-type semiconductor absorber layer. A second n-type semiconductor (e.g., undoped ZnO) is formed on the buffer layer and a front contact (i.e., a transparent conducting layer (e.g., ZnO:Al or In₂O₃:Sn)) is formed on the second n-type semiconductor.

Conventional thin film photovoltaic cells comprising CdTe and Cu(In,Ga)(S,Se)₂ absorber layers are typically produced starting with a glass, metal or polymer substrate. Depositing molybdenum on the substrate to form a bottom conducting layer. The absorber layer is deposited over the molybdenum by sputtering followed by a selenization process. The next step is the deposition of a CdS buffer layer by chemical bath or sputtering deposition process to form a pn junction between the absorber layer and the buffer layer. Then an intrinsic ZnO layer is sputter deposited over the CdS buffer layer. In the final step an Al doped ZnO layer is deposited over the intrinsic ZnO layer. The Al doped ZnO layer forms an optically transparent conductive layer. Electrodes may then be evaporated on the top of the Al doped ZnO layer to make electrical contact. When sunlight shines on the cell, a voltage develops between the bottom and the top electrode, allowing for power to be extracted from the cell.

An example of a CdTe or Cu(In,Ga)(S,Se)₂ based thin film photovoltaic cell and manufacturing method is disclosed in U.S. Patent No. 2009/0223556 by Niesen et al. Niesen et al. disclose a process of making a thin-film photovoltaic device comprising the steps of a) providing a first layer of a chalkopyrite semiconductor of a first doping type; b) after step a), depositing a second layer of intrinsic zinc oxide by chemical vapor deposition; and c) after step b), depositing a third layer of zinc oxide semiconductor of a second doping type opposite to the first doping type by a method other than chemical vapor deposition.

Notwithstanding, there remains a need to replace some or all of the layers in the conventional thin film photovoltaic device with solution depositable materials, allowing for the economical manufacture of thin film photovoltaic cells by continuous roll to roll fabrication techniques.

The present invention provides a thin film photovoltaic cell, comprising: a substrate; a back contact provided on the substrate; a p-type semiconductor absorber layer provided on the back contact; a n-type semiconductor layer provided on the p-type semiconductor absorber layer; a dielectric organic material layer provided on the n-type semiconductor layer; a transparent conductive film provided on the dielectric organic material layer; and optionally, an antireflective layer provided on the transparent conductive film.

The present invention provides a method for manufacturing a thin film photovoltaic cell, comprising: providing a substrate; providing a back contact; providing a p-type semiconductor absorber layer, wherein the back contact is in electrical communication with the p-type semiconductor absorber layer; providing an n-type semiconductor layer on the p-type semiconductor absorber layer; providing a dielectric organic material layer precursor; applying the dielectric organic material layer precursor to a surface of the n-type semiconductor layer and forming a dielectric organic material layer on the surface of the n-type semiconductor layer; and, forming a transparent conductive film on the dielectric organic material layer; and, optionally, providing a front electrode in electrical contact with the transparent conductive film.

### DETAILED DESCRIPTION

The thin-film photovoltaic stack of the present invention substitutes a dielectric layer for the conventional semiconductor intrinsic zinc oxide layer interposed between a transparent conductive film (i.e., a transparent front contact) and an n-type semiconductor layer (i.e., a buffer layer). The thin-film photovoltaic stack of the present invention enables the substitution of a solution depositable material for a conventionally chemical vapor deposited intrinsic zinc oxide layer.

The terms "over" and "on" as used herein and in the appended claims both inclusively include "directly on" (i.e., no intermediate materials, elements or space interposed therebetween) and "indirectly on" (i.e., intermediate materials, elements or space interposed therebetween). For example, providing a layer "on" a substrate can include forming the layer directly on the substrate with no intermediate materials between the layer and the substrate; as well as providing the layer indirectly on the substrate with one or more interveining materials interposed between the layer and the substrate.

Substrate material used in the thin film photovoltaic cell of the present invention includes those substrate materials commonly used in photovoltaic cells. Suitable substrate materials include, for example, glass, metals and polymeric materials. For glass substrates, it may be desirable to provide a transparent, conductive coating, such as tin oxide (SnO₂) on the glass substrate. For large scale manufacturing (e.g., using roll-to-roll techniques)--flexible substrates are preferred. Suitable flexible substrates include, for example, thin metal foils (e.g., foils made of aluminum, niobium, titanium, chromium, iron, bismuth, antimony and steel); and polymeric materials (e.g., films made of polyether ether ketone; polyimide and polyester).

Back contact used in the thin film photovoltaic cell of the present invention facilitates electrical connection of the thin film photovoltaic cell in an electrical circuit. The back contact optionally covers a whole surface of the substrate. Alternatively, the back contact optionally covers a portion of a surface of the substrate. Optionally, the back contact is not interfaced with the substrate, rather, the back contact is optionally connected to a side of the p-type semiconductor absorber layer. The back contact can be made of molybdenum, aluminum, silver, zinc oxide or tin oxide (SnO₂). Preferably, the back contact is made from at least one of molybdenum, silver and aluminum. Optionally, the back contact is made from molybdenum. Optionally, the back contact is made from aluminum. Optionally, the back contact is made from silver.

P-type semiconductor absorber material used in the thin film photovoltaic cell of the present invention is sometimes referred to in the art as an "absorber layer material". The p-type semiconductor absorber layer can comprise any p-type semiconductor absorber material conventionally used in thin film photovoltaic cells. The p-type semiconductor absorber material is preferably selected from direct band gap materials having high absorption coefficients. Examples of preferred p-type semiconductor absorber materials include, for example, cadmium telluride (CdTe), kesterites--Cu₂(Zn,Fe)Sn(S,Se)₄--and copper chalcopyrites. Copper chalcopyrites suitable for use as the p-type semiconductor absorber material in the thin film photovoltaic cells of the present invention comprise Group 1a-1b-3a-6a mixed-metal chalcogenide materials, including for example, copper-indium-diselenide (CuInSe₂), copper-gallium-diselenide (CuGaSe₂) and copper-indium-gallium-diselenide (CuIn₁₋ₓGaₓSe₂). Copper chalcopyrites used as an absorber material in thin film photovoltaic cells are commonly referred to by those in the art as CIGS materials. A preferred p-type semiconductor absorber material is according to the formula Na_{L}CuₘIn_{(1-d)}Ga_{d}S_{(2+e)(1-f)}Se_{(2+e)f}; wherein 0 ≤ L ≤ 0.75, 0.25 ≤ m ≤ 1.5,0 ≤ d ≤ 1, -0.2 ≤ e ≤ 0.5, 0 < f ≤ 1; wherein 0.5 ≤ (L + m) ≤ 1.5 and 1.8 ≤ {(2+e)f+ (2+e)(1-f)} ≤ 2.5)). The p-type semiconductor absorber layer optionally completely covers a surface of the back contact (or a surface of the substrate for devices wherein the back contact is electrically interface with a side of the p-type semiconductor absorber layer). Alternatively, the p-type semiconductor absorber material optionally covers a portion of a surface of the back contact (or the substrate).

N-type semiconductor material used in the thin film photovoltaic cell of the present invention is sometimes referred to in the art as a "buffer layer material". The n-type semiconductor layer can comprise any n-type semiconductor material conventionally used in thin film photovoltaic cells. Preferably, the n-type semiconductor material used is selected from cadmium sulfide (CdS); zinc sulfide (ZnS); indium sulfide (In₂S₃); zinc selenide (ZnSe), indium selenide (InSe), zinc indium selenide ((Zn,In)Se); zinc oxide, zinc sulfide, zinc oxide sulfide (Zn(O,S)); and magnesium zinc (MgZn). More preferably, the n-type semiconductor material used is selected from cadmium sulfide (CdS) and zinc sulfide (ZnS). Most preferably, the n-type semiconductor material used is CdS. The n-type semiconductor layer optionally completely covers a surface of the p-type semiconductor absorber layer. Alternatively, the n-type semiconductor layer optionally covers a portion of a surface of the p-type semiconductor absorber layer.

The n-type semiconductor layer is preferably deposited in a layer having an average thickness of 10 to 150 nm; more preferably 10 to 100 nm; still more preferably 40 to 100 nm; most preferably 40 to 60 nm on the p-type semiconductor absorber layer.

Dielectric organic material used in the thin film photovoltaic cell of the present invention can be any polymeric material suitable for use as a capacitor dielectric, which also exhibits a transparency of ≥ 80% across the electromagnetic spectrum from 400 nm to 1200 nm. Preferably, the dielectric organic material used exhibits a resistivity of ≥ 10⁴ Ω·cm; more preferably ≥ 10⁵ Ω·cm; still more preferably ≥ 10⁷ Ω·cm; most preferably ≥ 10¹⁰ Ω·m. Preferably, the dielectric organic material used exhibits a dielectric constant of ≥ 4; more preferably ≥ 5; most preferably ≥ 7. Preferably, the dielectric organic material used is a silsesquioxane, such as, alkyl silsesquioxane, aryl silsesquioxane, hydrido silsesquioxane and mixtures thereof. More preferably, the dielectric organic material used is a C₁₋₁₀ alkyl silsesquioxane. Most preferably, the dielectric organic material used is selected from methyl silsesquioxane, ethyl silsesquioxane, propyl silsesquioxane and butyl silsesquioxane. The dielectric organic material optionally completely covers a surface of the n-type semiconductor layer. Alternatively, the dielectric organic material optionally covers a portion of a surface of the n-type semiconductor layer.

The thin film photovoltaic cell of the present invention preferably comprises a dielectric organic material layer having an average thickness of 10 to 150 nm; more preferably 10 to 100 nm; still more preferably 40 to 100 nm; most preferably 40 to 90 nm interposed between a surface of the n-type semiconductor layer and a surface of the transparent conductive film.

Transparent conductive film material used in the thin film photovoltaic cell of the present invention can be any conventional transparent conductive material. The transparent conductive film material used can be selected from transparent conductive oxides (e.g., indium doped tin oxide, fluorine doped tin oxide, doped zinc oxide--such as aluminum doped zinc oxide--, indium doped cadmium oxide); a carbon nanotube network; graphene; a transparent conductive polymer (e.g., poly(3,4-ethylenedioxythiophene); poly(styrene sulfonate doped poly(3,4-ethylenedioxythiophene); poly(4,4-dioctylcyclopentadithiophene); iodine doped poly(4,4-dioctycyclopentadithiophene); and 2,3-dichloro-5,6-dicyano-1,4-benzoquinone doped poly(4,4-dioctycylopentadithiophene); nano networks (e.g., silver nanowire networks, silver nanoflake networks, silver nanocube networks, silver nanoparticle networks). Preferably, the transparent conductive film material used is an aluminum doped zinc oxide. The transparent conductive film can optionally completely cover a surface of the dielectric organic material layer or only selectively cover a portion of a surface of the dielectric organic material layer.

The thin film photovoltaic cell of the present invention preferably comprises a transparent conductive film having an average thickness of 10 to 150 nm; more preferably 50 to 125 nm; still more preferably 75 to 125 nm; most preferably 100 to 125 nm.

Optional antireflective material used in the thin film photovoltaic cell of the present invention can be selected from any antireflective material suitable for use in photovoltaic cells. The antireflective layer can optionally completely cover a surface of the transparent conductive film or can optionally selectively cover a portion of a surface of the transparent conductive film.

The thin film photovoltaic cell of the present invention optionally includes an electrode in electrical communication with the transparent conductive film and an electrode in electrical communication with the back contact to facilitate connection of the thin film photovoltaic cell into an electrical network.

The thin film photovoltaic cell of the present invention preferably exhibits a device efficiency of ≥ 9%; more preferably 9 to 18% as measured using an AM 1.5 G light source to simulate sunlight following the ASTM E927-05.

The thin film photovoltaic cell manufacturing method of the present invention, comprises: providing a substrate; providing a back contact; providing a p-type semiconductor absorber layer, wherein the back contact is in electrical communication with the p-type semiconductor absorber layer; providing an n-type semiconductor layer on the p-type semiconductor absorber layer; providing a dielectric organic material layer precursor; applying the dielectric organic material layer precursor to the n-type semiconductor layer, forming a dielectric organic material layer; and, forming a transparent conductive film on the dielectric organic material layer; optionally, providing a front electrode in electrical contact with the transparent conductive film.

In the thin film photovoltaic cell manufacturing method of the present invention, the back contact is provided in electrical communication with the p-type semiconductor absorber layer by any conventional processing method. For example, the back contact can be applied to a surface of the substrate (or to a side of the p-type semiconductor absorber layer) by sputtering, laminating, printing, sol gel, chemical bath deposition, electrodeposition, chemical vapor deposition, physical vapor deposition, atomic layer deposition, depositing a conductive seed layer, electroplating, spraying and pyrolysis. Optionally, the back contact is deposited as a uniform layer over a surface of the substrate (or to a side of the p-type semiconductor absorber layer). Optionally, the back contact is applied over a portion or portions of a surface of the substrate.

In the thin film photovoltaic cell manufacturing method of the present invention, the p-type semiconductor absorber layer is provided on a surface of the back contact (or on a surface of the substrate in applications wherein the back contact is associated with a side of the p-type semiconductor absorber layer) by any conventional processing method. For example, the p-type semiconductor absorber layer can be formed using evaporation, solution growth, sputtering, chemical vapor deposition and liquid deposition (e.g., wet coating, spray coating, spin coating, doctor blade coating). Optionally, the p-type semiconductor absorber layer is applied as a uniform layer over an entire surface of the back contact (or substrate). Optionally, the p-type semiconductor absorber layer is applied over a portion or portions of a surface of the back contact (or substrate).

Optionally, the p-type semiconductor absorber layer comprises a Group 1a-1b-3a-6a material. When the p-type semiconductor absorber layer comprises a Group 1a-1b-3a-6a material, the method of the present invention can further comprise: optionally, providing a Group 1a source comprising sodium; providing a Group 1b source; providing a Group 3a source; optionally providing a Group 6a sulfur source; providing a Group 6a selenium source; forming a Group 1a-1b-3a-6a precursor material on the substrate by optionally using the Group 1a source to deposit sodium, using the Group 1b source to deposit a Group 1b material, using the Group 3a source to deposit a Group 3a material, optionally using the Group 6a sulfur source to deposit a sulfur material and using the Group 6a selenium source to deposit a selenium material; treating the precursor material to form a Group 1a-1b-3a-6a material having a formula Na_{L}XₘYₙSₚSe_{q}; wherein X is at least one Group 1b material selected from copper and silver, preferably copper; Y is at least one Group 3a material selected from aluminum, gallium and indium, preferably indium and gallium; 0 ≤ L ≤ 0.75; 0.25 ≤ m ≤ 1.5; n is 1;0 ≤ p ≤ 2.5; and, 0 ≤ q ≤ 2.5. Preferably, 0.5 ≤ (L+m) ≤ 1.5 and 1.8 ≤ (p + q) ≤ 2.5. Preferably, Y is (In_{1-b}Ga_{b}), wherein 0 ≤ b ≤ 1. More preferably, the Group 1a-1b-3a-6a material is according to the formula Na_{L}CuₘIn_{(1-d)}Ga_{d}S_{(2+e)(i-f)}Se_{(2+e)f}; wherein 0 ≤ L ≤0.75, 0.25≤m≤1.5,0≤d≤1,-0.2≤e≤0.5,0<f≤1; wherein 0.5≤(L+m)≤1.5 and 1.8 ≤ {(2+e)f+ (2+e)(1-f)} ≤ 2.5. Optionally, one or more of the Group 1a source, Group 1b source, Group 3a source, Group 6a sulfur source and the Group 6a selenium source are combined. The components of the precursor material can be treated by known methods to form the Group 1a-1b-3a-6a material having formula Na_{L}XₘYₙSₚSe_{q}.

Group 1a source suitable for use in accordance with the present invention include any conventional vehicles for depositing sodium (a Group 1a material) using liquid deposition techniques, vacuum-evaporation techniques, chemical vapor deposition techniques, sputtering techniques or any other conventional process for depositing sodium on a substrate. Preferably, the Group 1a source can be incorporated with one or more of the Group 1b source, the Group 3a source, the Group 6a sulfur source or the Group 6a selenium source. Alternatively, the sodium may be deposited using a separate Group 1a source.

Group 1b source suitable for use in accordance with the present invention include any conventional vehicles for depositing a Group 1b material using liquid deposition techniques, vacuum-evaporation techniques, chemical vapor deposition techniques, sputtering techniques or any other conventional process for depositing a Group 1b material. Preferably, the Group 1b material includes at least one of copper and silver; more preferably copper. Optionally, the Group 1b source contains selenium in addition to a Group 1b material (e.g., CuₕSeⱼ, AgₕSeⱼ).

Group 3a source suitable for use in accordance with the present invention include any conventional vehicles for depositing a Group 3a material using liquid deposition techniques, vacuum-evaporation techniques, chemical vapor deposition techniques, sputtering techniques or any other conventional process for depositing a Group 3a material. Preferably, the Group 3a material includes at least one of gallium, indium and aluminum; more preferably gallium and indium. Optionally, the Group 3 a source contains selenium in addition to the Group 3 a material (e.g., InSe, GaSe). Optionally, the Group 3a source contains copper and selenium in addition to the Group 3a material (e.g., CIGS nanoparticles).

Group 6a sulfur source suitable for use in accordance with the present invention include any conventional vehicles for depositing sulfur using liquid deposition techniques, vacuum-evaporation techniques, chemical vapor deposition techniques, sputtering techniques or any other conventional process for depositing sulfur.

Group 6a selenium source suitable for use in accordance with the present invention include any conventional vehicles for depositing selenium using liquid deposition techniques, vacuum-evaporation techniques, chemical vapor deposition techniques, sputtering techniques or any other conventional process for depositing selenium.

In the thin film photovoltaic cell manufacturing method of the present invention, the n-type semiconductor layer is provided on the p-type semiconductor absorber layer by any conventional processing method. For example, the n-type semiconductor layer can be formed using solution growth (e.g., chemical bath deposition), sputtering and evaporation. Optionally, the n-type semiconductor layer is applied over an entire surface of the p-type semiconductor absorber layer. Optionally, the n-type semiconductor layer is applied over a portion or portions of a surface of the p-type semiconductor absorber layer.

In the thin film photovoltaic cell manufacturing method of the present invention, the dielectric organic layer is provided on the n-type semiconductor layer by a liquid processing technique. Suitable liquid processing techniques include wet coating, spray coating, spin coating, doctor blade coating, contact printing, top feed reverse printing, bottom feed reverse printing, nozzle feed reverse printing, gravure printing, microgravure printing, reverse microgravure printing, comma direct printing, roller coating, slot die coating, meyerbar coating, lip direct coating, dual lip direct coating, capillary coating, ink-jet printing, jet deposition, spray pyrolysis and spray deposition. Optionally, the dielectric organic layer is applied as multiple discrete layers. Optionally, the dielectric organic layer is applied as a single uniform layer over an entire surface of the n-type semiconductor layer. Optionally, the dielectric organic layer is applied as a single layer over a portion or portions of a surface of the n-type semiconductor layer.

Preferably, the dielectric organic material is deposited on the n-type semiconductor material from a liquid solution. Preferably, the temperature of the n-type semiconductor material during deposition of the dielectric organic material is less than 100°C. Preferably, the dielectric organic material is subsequently cured at a temperature of less than 200 °C following its deposition on the n-type semiconductor material. Preferably, the dielectric organic material is deposited with a film thickness from 25 to 150 nm; more preferably 50 to 100 nm.

In the thin film photovoltaic cell manufacturing method of the present invention, the transparent conductive film is provided on the dielectric organic layer by any conventional processing method. For example, the transparent conductive film can be deposited using spin coating, spray deposition (including spray pyrolysis), chemical vapor deposition, physical vapor deposition and sputtering. Optionally, the transparent conductive film is a conductive oxide layer (e.g., aluminum doped zinc oxide layer), wherein the transparent conductive film is deposited using a solution processed transparent metal nanowire mesh material (i.e., spin coated, spray deposited). Optionally, the transparent conductive film is a transparent conductive oxide, wherein the transparent conductive film is deposited using chemical vapor deposition or sputtering. Optionally the transparent conductive film comprises silver nanorods.

Some embodiments of the present invention will now be described in detail in the following **Examples.**

### Examples 1-4: Thin film photovoltaic cells

Test thin film photovoltaic cells were prepared as follows: a layer of molybdenum was sputter deposited on a surface of a glass substrate to form a back contact having an average thickness of 1 µm. A CIGS type absorber layer (i.e., a p-type semiconductor absorber layer) having an average thickness of 2 µm was grown by coevaporation using the National Renewable Energy Laboratory 3 stage process (as described in, for example, United States Patent Nos. 5,441,897 and 5,436,204). A CdS layer (i.e., an n-type semiconductor layer) having an average thickness as noted in **Table 1** was then deposited onto the surface of the p-type semiconductor absorber layer by chemical bath deposition (CBD) from a 60°C solution of 0.0015 M CdSO4, 1.5 M NH4OH and 0.0075 M thiourea. A layer of silsesquioxane (i.e., dielectric organic layer) was then spin coated using the spin speed noted in **Table 1** on the CdS layer from a 2.8% solution of GR 650F methyl silsesquioxane (commercially available from Technoglass, Ohio) in propylene glycol methyl ether acetate (PGMEA) and then cured at 200 °C for 2 minutes. The thicknesses of deposited silsesquioxane layer is provided in **Table 1.** A layer of aluminum doped zinc oxide (i.e., transparence conductive film) was then sputter deposited on the silsesquioxane layer to a thickness of 120 nm from an Al₂O₃ doped ZnO target. Nickel/aluminum finger electrodes were then deposited on the aluminum doped zinc oxide layer using electron beam evaporation through a shadow mask. The active area of the photovoltaic cells was 0.5 cm². The efficiency of the cells was measured from current-voltage curves using an AM 1.5 G light source to simulate sunlight following the ASTM E927-05. The results are provided in **Table 1.**

**Table 1**

| **Ex. #** | **Spin Speed (rpm)** | **Silsesquioxane Thickness (nm)** | **CdS thickness (nm)** | **Eff (%)** |
|---|---|---|---|---|
| 1 | 1000 | 86 | 50 | 9.12 |
| 2 | 2500 | 51 | 50 | 10.37 |
| 3 | 1000 | 86 | 100 | 9.46 |
| 4 | 2500 | 51 | 100 | 9.6 |

## Claims

1. A thin film photovoltaic cell, comprising:
a substrate;
a back contact provided on the substrate;
a p-type semiconductor absorber layer provided on the back contact;
a n-type semiconductor layer provided on the p-type semiconductor absorber layer;
a dielectric organic material layer provided on the n-type semiconductor layer;
a transparent conductive film provided on the dielectric organic material layer; and, optionally, an antireflective layer provided on the transparent conductive film.

2. The thin film photovoltaic cell of claim 1, wherein the dielectric organic material layer comprises a silsesquioxane.

3. The thin film photovoltaic cell of claim 2, wherein the dielectric organic material layer has an average thickness of 10 to 150 nm.

4. The thin film photovoltaic cell of claim 1, wherein the substrate is a thin metal foil or a polymeric material.

5. The thin film photovoltaic cell of claim 2, wherein the back contact is molybdenum.

6. The thin film photovoltaic cell of claim 2, wherein the p-type semiconductor absorber layer comprises a p-type semiconductor absorber material selected from CdTe and a CIGS material according to the formula Na_{L}CuₘIn_{(1-d)}Ga_{d}S_{(2+e)(1-f)}Se_{(2+e)f}; wherein 0 ≤ L ≤ 0.75, 0.25 ≤ m ≤ 1.5, 0 ≤ d ≤ 1, -0.2 ≤ e ≤ 0.5, 0 ≤ 0 < f ≤ 1; wherein 0.5 ≤ (L+m) ≤ 1.5 and 1.8 ≤ {(2+e)f + (2+e)(1-f)} ≤ 2.5)).

7. The thin film photovoltaic cell of claim 6, wherein the n-type semiconductor layer comprises cadmium sulfide and has an average thickness of 10 to 150 nm.

8. The thin film photovoltaic cell of claim 7, wherein the transparent conductive film comprises aluminum doped zinc oxide and has an average thickness of 10 to 150 nm.

9. The thin film photovoltaic cell of claim 8, wherein the thin film solar cell exhibits a device efficiency of ≥ 9%, measured from current-voltage curves using an AM 1.5 G light source to simulate sunlight following the ASTM E927-05.

10. A method for manufacturing a thin film photovoltaic cell, comprising:
providing a substrate;
providing a back contact;
providing a p-type semiconductor absorber layer, wherein the back contact is in electrical communication with the p-type semiconductor absorber layer;
providing an n-type semiconductor layer on the p-type semiconductor absorber layer;
providing a dielectric organic material layer precursor;
applying the dielectric organic material layer precursor to a surface of the n-type semiconductor layer and forming a dielectric organic material layer on the surface of the n-type semiconductor layer; and,
forming a transparent conductive film on the dielectric organic material layer; and, optionally, providing a front electrode in electrical contact with the transparent conductive film.
